(19) Europäisches Patentamt
European Patent Office
Office européen des brevets

(11) **EP 4 489 299 A1**

(12) **EUROPEAN PATENT APPLICATION**

(43) Date of publication:
08.01.2025 Bulletin 2025/02

(21) Application number: 23275101.6

(22) Date of filing: 07.07.2023

(51) International Patent Classification (IPC):
$H03B\ 21/00^{(2006.01)}$   $H04B\ 1/04^{(2006.01)}$
$H04B\ 1/10^{(2006.01)}$   $H04B\ 1/12^{(2006.01)}$

(52) Cooperative Patent Classification (CPC):
H03B 21/00

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: BAE SYSTEMS plc
London SW1Y 5AD (GB)

(72) Inventor: **The designation of the inventor has not yet been filed**

(74) Representative: **BAE SYSTEMS plc
Group IP Department
Warwick House
P.O. Box 87
Farnborough Aerospace Centre
Farnborough Hampshire GU14 6YU (GB)**

(54) **IMPROVEMENTS IN AND RELATING TO OSCILLATORS**

(57) Disclosed is an oscillator system for producing an RF output signal, comprising: a first signal source arranged to output a first signal at a first frequency; a signal splitter to split the first signal into a first component signal and a substantially identical second component signal; a notch filter and a 180° phase shifter arranged in a signal path of the first component signal, arranged with either the notch filter or the phase shifter acting first and the other acting second, to produce a modified first component signal; and a signal combiner arranged to combine the second component signal and the modified first component signal to produce the RF output signal.

Fig.1

EP 4 489 299 A1

**Description**

FIELD

The present invention relates to an improved oscillator design. It finds particular application where a Stabilised Local Oscillator (STALO) is required, but may be used in other, more general, applications. One particular application of interest is in the field of RADAR design, where stable, low phase noise signals having low spurious output components is of particular importance. Such a STALO can provide significant performance improvements over a non-STALO design.

BACKGROUND

The design of a Stabilised Local Oscillator (STALO) requires the production of low phase noise, low spurious output signals used to provide the local oscillator signals for the double super-heterodyne up-conversion and down-conversion RF processing required within a radar system.

The RF processing primarily uses mixers to provide either the upper or lower side-band signals required by the RF up or down converters. Mixers are non-linear devices and generate additional signals related to the local oscillator signal and the RF input frequency.

The equation below defines the expected output frequencies, F, from the mixer (where $F_R$ is the RF frequency and $F_L$ is the local oscillator frequency):

$$F = +/- \; m * F_R +/- n * F_L$$

Where

m = 1,2,3...
n = 1,2,3 ...

These mixer products are predictable within the design of the frequency plan. However, there are occasions when the operational frequency bands are limited and these mixer spurs can be problematic. It is an aim of an embodiment of the present invention to address these shortcomings in the prior art and provide an oscillator having a "cleaner" output spectrum. Ideally, an output should have no spurs at all. This is practically impossible and so an aim is to reduce the magnitude of any spurs significantly.

SUMMARY

According to a first aspect of the present invention, there is provided an oscillator system for producing an RF output signal, comprising: a first signal source arranged to output a first signal at a first frequency; a signal splitter to split the first signal into a first component signal and a substantially identical second component signal; a notch filter and a 180° phase shifter arranged in a signal path of the first component signal, arranged with either the notch filter or the phase shifter acting first and the other acting second, to produce a modified first component signal; and a signal combiner arranged to combine the second component signal and the modified first component signal to produce the RF output signal.

In an embodiment, the first signal source is one of a Voltage Controlled Oscillator ,VCO, Digital to Analog Convertor, DAC, Arbitrary Waveform Generator, Direct Digital Synthesiser, DDS, Signal Generator, Voltage Controlled Crystal Oscillator, VCXO, Oven Controlled Crystal Oscillator, OCXO, Numerically Controlled Oscillator, NCO, Dielectric Resonating Oscillator, DRO, or Frequency Multiplier, VCO, DDS, DAC, a mixer [any others?]

In an embodiment, the first signal source is a mixer which is arranged to output the first signal, the oscillator system further comprising a second signal source arranged to output a second signal at a second frequency and a third signal source arranged to output a third signal at a third frequency, whereby the second and third signals are mixed in the mixer to produce the first signal.

In an embodiment, the second and third signal sources are each one of a Voltage Controlled Oscillator ,VCO, Digital to Analog Convertor, DAC, Arbitrary Waveform Generator, Direct Digital Synthesiser, DDS, Signal Generator, Voltage Controlled Crystal Oscillator, VCXO, Oven Controlled Crystal Oscillator, OCXO, Numerically Controlled Oscillator, NCO, Dielectric Resonating Oscillator, DRO, a mixer or Frequency MultiplierVCO, DDS, DAC, a mixer [any others?].

In an embodiment, the second signal is a local oscillator signal and the third signal is an RF or IF signal.

In an embodiment, there is further provided a calibration data store, operable to store a plurality of calibration parameters associated with respective frequencies of operation, said plurality of calibration parameters being used to configure at least one component of the oscillator system.

According to a second aspect of the present invention, there is provided a method of providing a desired signal comprising a component having a single desired frequency, comprising the steps of: providing an input signal comprising the desired frequency as well as at least one unwanted frequency; splitting the input signal into substantially identical first and second components; notch filtering and 180° phase shifting the first component to produce a modified first component; combining the modified first component and the second component to provide the desired signal.

BRIEF DESCRIPTION OF THE FIGURES

Embodiments of the invention will now be described by way of example only with reference to the figures, in which:

Figure 1 shows a schematic representation of a first embodiment of the present invention;

Figure 2 shows a schematic representation of a second embodiment of the present invention;

Figure 3 shows a more detailed schematic representation of a first embodiment of the present invention, including tuning/calibration elements; and

Figure 4 shows a flowchart illustrating a method according to an embodiment of the present invention.

DETAILED DESCRIPTION

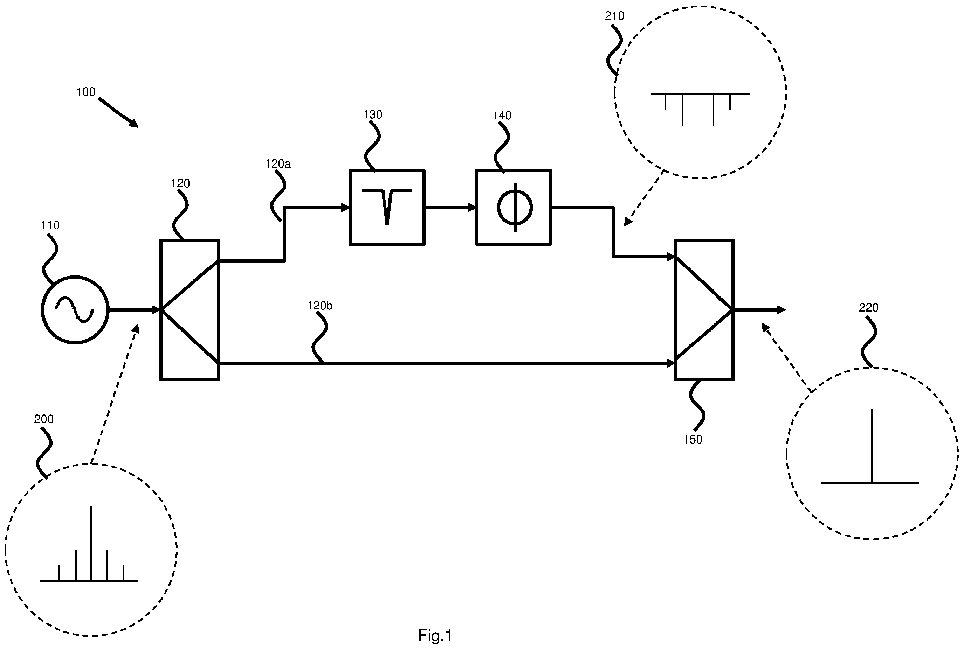

An embodiment of the present invention is shown schematically in Figure 1. This shows a STALO 100 comprising various component parts, the operation of which will be described below.

An oscillator 110 is provided which produces a primary output signal and a number of additional signals as lower magnitude sidebands. A sample spectrum is shown as 200. The spurious sidebands tend to be distributed symmetrically about the primary (wanted) signal and also tend to decay in magnitude at frequencies further removed from the primary signal. However, this need not be the case and any signals present which are not the primary signal are generally regarded as undesirable.

The output from oscillator 110 is applied to signal splitter 120, which produces two substantially identical outputs form the input signal applied. Each output signal is applied to a respective signal path 120a, 120b. Path 120b is passed directly and unmodified in any way to an input of power combiner 150. Path 120a is modified by the action of notch filter 130 and phase shifter 140.

Notch filter 130 is a filter also known as a band stop filter, more particularly a narrow band stop filter, and is arranged to remove or attenuate a range of frequencies. Preferably, the range of frequencies is narrow and corresponds to the wanted or primary frequency produced by the oscillator 110. The effect of notch filter 130 is to effectively remove the wanted signal and allow only the unwanted signals to pass.

These unwanted signals or sidebands are then passed to a phase shifter 140. Specifically the phase shifter 140 applies a 180° phase shift and effectively inverts the signals applied thereto.

The net result of the actions of notch filter 130 and phase shifter 140 is shown in the illustrative spectrum 210 which shows the signals present at the output of the phase shifter 140. Note the absence of the central primary frequency and the inversion of the unwanted sidebands.

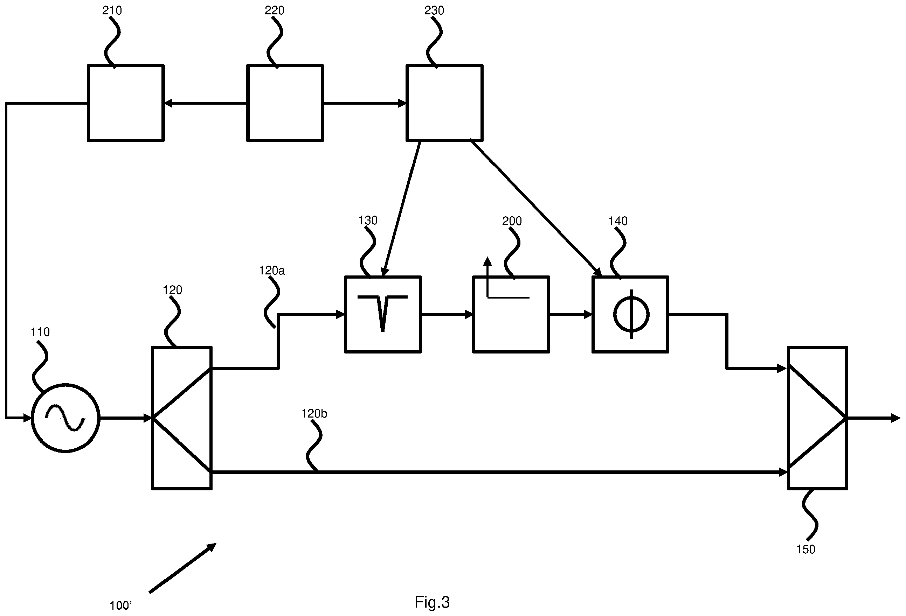

The notch filter 130 should be relatively fast-tuning and should be calibrated for each of possibly several STALO frequencies which are required at the output of the STALO 100. The phase shifter 140 also requires calibration for each of the possibly several STALO frequencies. Details of the calibration process are provided later in connection with Figure 3.

The respective path lengths of signal paths 120a and 120b should be substantially identical, hence the need for the calibration referred to above. Proper calibration ensure an optimal result.

At this point, it is important to note that the notch filter 130 and phase shifter 140 although shown in Figure 1 as the notch filter acting before the phase shifter, the order of operation can be inverted i.e. the phase shifter 140 can be positioned before the notch filter 130, such that it acts first. The net effect in either case is identical, with the spectrum 210 at the first input to power combiner 150 being the same regardless of the sequence of operation of the notch filter 130 and phase shifter 140.

Power combiner 150 has two inputs. As mentioned previously, one input is from signal path 120b and is an unmodified output from power splitter 120. The other input is derived from signal path 120a, as described immediately above.

Power combiner 150 acts to sum the two signals applied to its inputs. The two spectrums illustrated at 200 and 210 are summed such that the inverted unwanted sideband signals are effectively subtracted from the original spectrum, leaving only the wanted central frequency. The output of combiner 150 is shown a spectrum 220, consisting of only the wanted central frequency.

Note that oscillator 110 may be any suitable nominally single frequency source, such as, but not limited to, a Voltage Controlled Oscillator (VCO), Digital to Analog Convertor (DAC), Arbitrary Waveform Generator, Direct Digital Synthesiser (DDS), Signal Generator, Voltage Controlled Crystal Oscillator (VCXO), Oven Controlled Crystal Oscillator (OCXO), Numerically Controlled Oscillator (NCO), Dielectric Resonating Oscillator (DRO) or Frequency Multiplier.

The majority of individual components referred to herein are available as Commercial Off the Shelf, COTS, components. By way of example only, the following are examples of suitable components, noting that this is not intended to be an exhaustive list and neither does it preclude the possibility of designing and procuring bespoke devices, as desired.

The Power Divider 120 and Power Combiner could be Mini-Circuits EP2W+. The coupler 200 could be Mini-Circuits BDCA-16-30+. The phase shifter 140 could be Qorvo TGP2108-SM. The notch filter could be Atlanta Microwave AM3129.

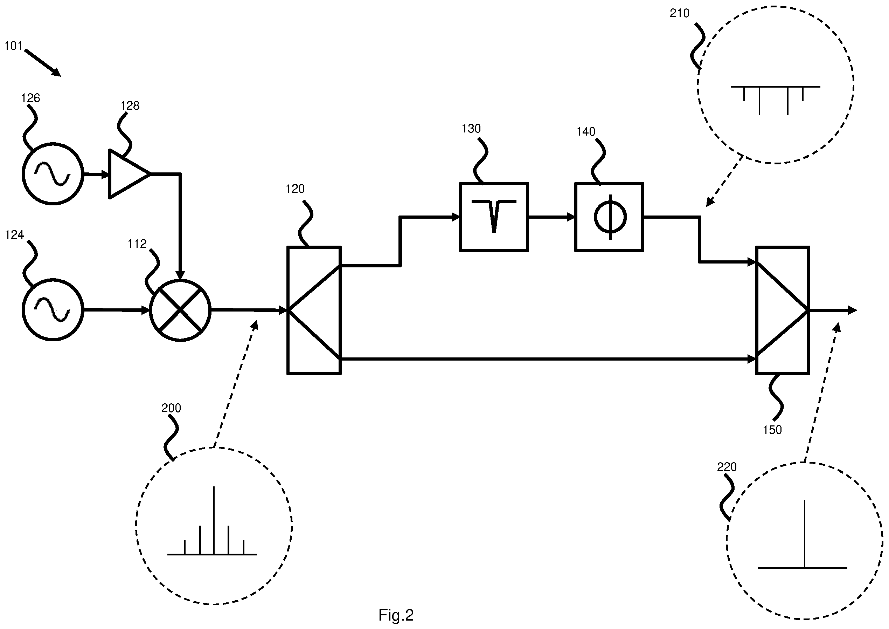

Figure 2 shows a second embodiment of the present invention, which differs slightly to the first embodiment of Figure 1, but only in the earlier stages before the power splitter 120. All subsequent operations are identical with those described in relation to Figure 1 and so are not repeated for reasons of brevity.

In the embodiment of Figure 2, the STALO 101 shows a structure including a pair of signal sources which are mixed to produce a signal which is then provided to power splitter 120 as an input signal. Such a structure is used wherein one of the two signal sources is a local oscillator (LO) and the other is a Radio Frequency (RF) or Intermediate Frequency (IF) oscillator.

Signal source 124 produces a signal which is mixed with the signal produced from signal source 126 in mixer 112. Mixer 112 uses an inherently non-linear process to multiply the signals and so even if the outputs of signal sources 124 and 126 are ideal and include only a single frequency, the output of mixer 112 will inevitably include some unwanted sideband signals as described previously and illustrated in spectrum 200, as before.

Note that signal source 124 produces the RF or IF signal and signal source 126 produces the LO signal. Note that the output of signal source 126 may be amplified if required by amplifier 128.

The similarity between the first and second embodiments is that the input to signal splitter 120 typically comprises a plurality of signals forming a spectrum including a wanted and several unwanted signals at discrete frequencies.

Figure 3 shows a slightly different version 100' of the first embodiment of Figure 1, incorporating additional elements which are provided for the purpose of tuning and/or calibration. Like-numbered elements are as described previously. The additional components relate only to the tuning and/or calibration of the system and are not normally required during normal operation.

Frequency controller 220 is arranged to control the frequency of the desired output frequency. It, in turn, provides a signal to oscillator controller 210, which directly controls the signal source or oscillator 110. At the same time, the frequency controller 220 interfaces with the calibration data store 230, which stores certain parameters associated with the calibration, as will be described. The calibration data store interfaces with the notch filter 130 and phase shifter 140.

Provided immediately after the notch filter 130 is a test coupler 200, which samples the output of the notch filter directly.

The calibration process involves the frequency controller 220 setting a centre frequency of operation, $F_c$. The output of the notch filter 130 is measured by the test coupler 200, with the notch filter control voltage set to a minimum. The path lengths between power splitter 120 and the power combiner 150, operating at $F_c$ should be adjusted to be phase matched when the notch filter is set to $F_c$ and the phase shifter 140 is set to 0°.

Then, the notch filter 130 control voltage is adjusted to achieve maximum suppression of the carrier frequency as seen at the output of the test coupler 200. The phase shifter 140 is adjusted to achieve the maximum suppression of spurious signals, as measured at the output of the power combiner 150. At this point, values of notch control voltage and phase shifter settings are saved for $F_c$.

This process is then repeated for one or more other output frequencies, whereby the relevant values for the notch filter control voltage and phase shifter settings are stored for each frequency of interest.

In this way, the notch filter 130 and phase shifter 140 can be configured using values stored in the calibration data store 230 for any desired frequency of interest.

Note that a similar arrangement may be provided for the embodiment of Figure 2. The only substantive difference is that the oscillator controller 210 is arranged to provide separate control signals to the two oscillators 124, 126.

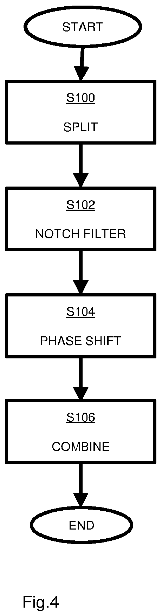

Figure 4 shows a flowchart illustrating steps involved in an embodiment of the invention. At step S100, an input signal to power splitter 120 is split into two substantially identical components.

At step S102, the first of the two components is notch filtered by notch filter 130 to remove a frequency component at a desired frequency.

At step S104, the notch filtered signal is then phase shifted by 180° to produce a signal for inputting to power combiner 150.

At step S106, the output from step S104 is combined in power combiner 150 with the second of the two components from step S100 to yield a desired output signal which comprises substantially the desired signal only.

**Claims**

1. An oscillator system for producing an RF output signal, comprising:

   a first signal source arranged to output a first signal at a first frequency;
   a signal splitter to split the first signal into a first component signal and a substantially identical second component signal;
   a notch filter and a 180° phase shifter arranged in a signal path of the first component signal, arranged with either the notch filter or the phase shifter acting first and the other acting second, to produce a modified first component signal; and
   a signal combiner arranged to combine the second component signal and the modified first component signal to produce the RF output signal.

2. The oscillator system of claim 1 wherein the first signal source is one of a Voltage Controlled Oscillator ,VCO, Digital to Analog Convertor, DAC, Arbitrary Waveform Generator, Direct Digital Synthesiser, DDS, Signal Generator, Voltage Controlled Crystal Oscillator, VCXO, Oven Controlled Crystal Oscillator, OCXO, Numerically Controlled Oscillator, NCO, Dielectric Resonating Oscillator, DRO, or Frequency Multiplier.

3. The oscillator system of claim 2 wherein the first signal source is a mixer which is arranged to output the first signal, the oscillator system further comprising a second signal source arranged to output a second signal at a second frequency and a third signal source arranged to output a third signal at a third frequency, whereby the second and third signals are mixed in the mixer to produce the first signal.

4. The oscillator system of claim 3 wherein the second and third signal sources are each one of a Voltage Controlled Oscillator ,VCO, Digital to Analog Convertor, DAC, Arbitrary Waveform Generator, Direct Digital Synthesiser, DDS, Signal Generator, Voltage Controlled Crystal Oscillator, VCXO, Oven Controlled Crystal Oscillator, OCXO, Numerically Controlled Oscillator, NCO, Dielectric Resonating Oscillator, DRO, a mixer or Frequency Multiplier

5. The oscillator system of claim 3 or 4 wherein the second signal is a local oscillator signal and the third signal is an RF or IF signal.

6. The oscillator system of any preceding claim further comprising a calibration data store, operable to store a plurality of calibration parameters associated with respective frequencies of operation, said plurality of calibration parameters being used to configure at least one component of the oscillator system.

7. A method of providing a desired signal comprising a component having a single desired frequency, comprising the steps of:

   providing an input signal comprising the desired frequency as well as at least one unwanted frequency;
   splitting the input signal into substantially identical first and second components;
   notch filtering and 180° phase shifting the first component to produce a modified first component;
   combining the modified first component and the second component to provide the desired signal.

Fig.1

Fig.2

Fig.3

Fig.4

START → S100 SPLIT → S102 NOTCH FILTER → S104 PHASE SHIFT → S106 COMBINE → END

**EP 4 489 299 A1**

Europäisches
Patentamt

European
Patent Office

Office européen
des brevets

# EUROPEAN SEARCH REPORT

Application Number

EP 23 27 5101

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 056 481 B1 (BROADCOM CORP [US]) 28 December 2016 (2016-12-28) * figure 3 * | 1,2,6,7 | INV. H03B21/00 H04B1/04 H04B1/10 |
| A | GB 2 500 067 A (RENESAS MOBILE CORP [JP]) 11 September 2013 (2013-09-11) * figures 4, 5 * | 1-7 | H04B1/12 |
| X | US 6 151 373 A (DODLEY JEEVAN PRAKASH [US]) 21 November 2000 (2000-11-21) * column 3, line 36 – line 38; figures 1-3 * | 1-7 | |

| | | | TECHNICAL FIELDS SEARCHED (IPC) |
|---|---|---|---|
| | | | H03B H04B |

The present search report has been drawn up for all claims

| Place of search | Date of completion of the search | Examiner |
|---|---|---|
| Munich | 15 December 2023 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 27 5101**

This annex lists the patent family members relating to the patent documents cited in the above-mentioned European search report.
The members are as contained in the European Patent Office EDP file on
The European Patent Office is in no way liable for these particulars which are merely given for the purpose of information.

**15-12-2023**

| Patent document cited in search report | | Publication date | Patent family member(s) | | Publication date |
|---|---|---|---|---|---|
| EP 2056481 | B1 | 28-12-2016 | CN | 101431342 A | 13-05-2009 |
| | | | EP | 2056481 A2 | 06-05-2009 |
| | | | HK | 1132102 A1 | 12-02-2010 |
| | | | KR | 20090045086 A | 07-05-2009 |
| | | | TW | 200939647 A | 16-09-2009 |
| | | | US | 2009111418 A1 | 30-04-2009 |
| GB 2500067 | A | 11-09-2013 | NONE | | |
| US 6151373 | A | 21-11-2000 | CA | 2228260 A1 | 03-10-1998 |
| | | | CN | 1198046 A | 04-11-1998 |
| | | | EP | 0874469 A2 | 28-10-1998 |
| | | | JP | H10303767 A | 13-11-1998 |
| | | | US | 6151373 A | 21-11-2000 |

EPO FORM P0459

For more details about this annex : see Official Journal of the European Patent Office, No. 12/82